# EUROPÄISCHE PATENTSCHRIFT

(11) **EP 2 849 549 B1**
(45) Veröffentlichungstag und Bekanntmachung des Hinweises auf die Patenterteilung: **22.06.2016**
(21) Anmeldenummer: 14184427.4
(22) Anmeldetag: 11.09.2014
(51) Int. Cl.: H05K 3/34, H02M 7/00, H02K 29/08, H02K 11/00, H05K 1/05, H05K 1/02, H02J 7/34

(54) **Anordnung elektrischer Bauteile und elektrischer Antriebsmotor mit einer solchen Bauteileanordnung**
Arrangement of electronic components and drive motor with such an arrangement
Agencement de composants électroniques et moteur d'entraînement avec un tel agencement

(30) Priorität: 16.09.2013 CH 15842013
(43) Veröffentlichungstag der Anmeldung: 18.03.2015
(73) Patentinhaber: Kolektor Micro-Motor d.o.o., 5280 Idrija (SI)
(72) Erfinder: Riehl, Christoph, 4148 Pfeffingen (CH)
(74) Vertreter: Grättinger Möhring von Poschinger Patentanwälte Partnerschaft

(56) Entgegenhaltungen:
- EP-A1- 1 909 377
- JP-A- H0 983 131
- US-A- 6 020 660

## Beschreibung

Die vorliegende Erfindung betrifft eine Bauteileanordnung für eine elektrische Steuerschaltung, insbesondere zur Steuerung elektrischer Antriebe, und einen elektrischen Antrieb mit einer solchen Bauteileanordnung, insbesondere einen bürstenlosen Antriebsmotor. Die Erfindung bezieht sich insbesondere auf eine elektrische Kontaktierungsmethode einer Leistungselektronik, die vorteilhaft bei einem bürstenlosen Elektroantrieb verwendet wird.

Aus dem Stand der Technik sind verschiedene Anordnungen zur Kontaktierung von elektrischen Bauteilen auf einer Leiterplatte bekannt. Als elektrische Bauteile sind nachfolgend Kondensatoren, Transistoren, Spulen, Drosseln, diverse Leistungsteile und dergleichen zu verstehen.

Bauteileanordnungen werden auch bei Steuerschaltungen für Gleichstrommotoren, insbesondere bei bürstenlosen Gleichstrommotoren, eingesetzt, bei welchen zur Stromwendung eine elektrische Schaltung verwendet wird. Ebenso werden solche Bauteileanordnungen bei Hochleistungsschaltnetzteilen eingesetzt. Ferner werden Statorspulen, die um einen Rotormagneten angeordnet sind, von einer elektronischen Schaltung zeitlich versetzt angesteuert. Eine derartige Schaltung ist z. B. aus der DE 102011110971 bekannt. Eine Leiterplatte mit einem runden Umfang wird zentriert zu einer Achse des Rotors angeordnet und erstreckt sich radial über Rotor und Stator. Auf der Leiterplatte sind die Bauteile der Schaltung mit einer Vergussmasse abdeckt (Chip-on- Bord Technik.). Aus der DE 102011014956 ist ebenfalls eine Steuerschaltung für einen bürstenlosen Gleichstrommotor bekannt. Die Steuerschaltung weist eine Kondensatoreinheit mit parallel geschalteten Kondensatoren auf, durch die eine Ausgangsspannung eingestellt werden kann. Die Kondensatoreinheit kann von einer gedruckten Leiterplatte, welche die übrigen Bauteile trägt, mechanisch unabhängig sein.

Typischerweise können Leistungsteile für derartige Motorsteuerungen z. B. auf konventionellen Leiterplatten aus Glasfasersubstrat oder Keramiksubstrat basieren. Bei Glasfasersubstraten müssen die Bauteile direkt mit einme Kühlkörper in Kontakt sein, da die Leiterplatte keine Wärme übertragen kann. Bei Keramiksubstraten kann ein direktes Bonding von Schaltelementen erfolgen, wobei ein verbesserter thermischer Kontakt zu einem Kühlkörper erreicht wird. Dabei fallen jedoch hohe Kosten an. Weiter können die Leistungsteile in diskreter Bauweise, ohne ein Trägermaterial erstellt werden. Die Bauteile sind mit Drähten oder mit gestanzten, bzw. geformten Kupferleiteren (bus bars) direkt verbunden. Hierfür ist ein hoher Aufwand erforderlich, da keine Standard-Fertigungsmethode verwendet werden kann. Ferner kann für die Leistungsteile eine Leiterplatte mit Metallträger (IMS = Insulated Metal Substrates) verwendet werden, die meist auf Aluminium, Stahl oder Kupfer basiert.

Die US 6424026 zeigt z. B. ein Leistungsteil mit einer gedruckten Schaltungsplatte (pcb), die auf einem Insulatormetallsubstrat (IMS) aufgesetzt ist, wobei eine Öffnung in der gedruckten Schaltungsplatte für einen Zugang zum IMS Substrat vorgesehen ist Die obere Oberfläche des IMS Substrats liegt nahe bei der oberen Oberfläche der gedruckten Schaltungsplatte, so dass eine Verdrahtung kurz gehalten werden kann. Weiter ist aus der US 7248483 ein Leistungsteil mit einer gedruckten Glasfaserplatte als pcb und einem Insulatormetallsubstrat gezeigt, bei dem Kondensatoren in herkömmlicherweise auf der Glasfaserplatte kontaktiert sind. Aus der DE 102004031878 ist ein elektrisches Mehrschichtbauelement mit einem Grundkörper bekannt, der aus mehreren über einander gestapelten Dielektrikumsschichten und dazwischen liegenden Elektrodenschichten aufgebaut ist. Lötkontakte auf der Unterseite des Grundkörpers sind mittels Durchkontaktierungen mit den Elektrodenschichten verbunden.

Bürstenlose Gleichstrommotoren kommen bei einer Vielzahl von Geräten zum Einsatz, welche die Anforderungen an die Motoren mit beeinflussen. Darunter sind grosse Anlagen, wie z. B. Webmaschinen, Werkzeugmaschinen, Waschmaschinen,Liftanlagen und auch Anwendungen in der Automobilindustrie, z. B. bei Hybridfahrzeugen, aber auch kleine Apparate, wie Ventilatoren oder Modellfahrzeuge.

Bei den bekannten Steuerschaltungen ist entweder eine kostspielige Integrationstechnik für die elektrischen Steuerbauteile, insbesondere für die Kondensatoren, einer Leiterplatte der Schaltung erforderlich, die sich in der Regel erst bei sehr hohen Stückzahlen amortisiert. Oder es wird eine Verdrahtung und/oder Durchkontaktierung nach herkömmlicher Art verwendet, bei der die Bauteile viel Raum einnehmen und für die umfangreiche Ätzarbeiten erforderlich werden.

Dokument EP-A1-1909377 beschreibt eine Bauteilanordnung gemäß des Oberbegriffs von Anspruch 1.

Es ist einer Aufgabe der vorliegenden Erfindung eine Anordnung von Bauteilen auf einer Leiterplatte für eine Steuerschaltung zu schaffen, die eine kompakte Bauweise ermöglicht, einfach und kostengünstig in der Herstellung ist, eine thermisch unproblematische Auslegung sowie eine leistungsfähige Steuerung für unterschiedliche Einsatzgebiete erlaubt. Weiter ist es eine Aufgabe der Erfindung einen Antriebsmotor bereit zu stellen, der für grosse Belastungen geeignet, platzsparend und kostengünstig ausgebildet und vielseitig einsetzbar ist.

Diese Aufgabe wird von der Erfindung durch eine Bauteileanordnung nach Anspruch 1 und einen elektrischen Antrieb nach Anspruch 14 gelöst. Vorteilhafte Ausgestaltungen und Ausführungsbeispiele sind in den abhängigen Ansprüchen beschrieben.

Eine Bauteileanordnung für eine elektrische Steuerschaltung nach der vorliegenden Erfindung umfasst eine Leiterplatte mit wenigstens einer Leiterbahn und wenigstens ein auf der Leiterplatte angeordnetes Bauteil. Vorzugsweise ist eine Vielzahl von Bauteilen vorgesehen. Die Bauteileanordnung ist für elektrische Steuerschaltungen vorgesehen, die z. B. eine Phasenschaltung oder eine Stromwendung bei elektrischen Einrichtungen steuern. Erfindungsgemäss ist das wenigstens eine Bauteil der Bauteileanordnung auf einer Seite einer Leiterbahn auf der Leiterplatte vorgesehen. Dabei verläuft die Leiterbahn entlang einer Ebene der Leiterplatte. Das Bauteil weist zwei elektrische Anschlussleitungen auf, die durch Durchgänge in der Leiterplatte ragen. Dies ist z. B. durch Anschlussdrähte realisiert, die durch Bohrungen in der Leiterplatte geführt sind. Eine der Anschlussleitungen ist mittels einer Kontaktstelle mit der Leiterbahn leitend verbunden ist, wobei die Kontaktstelle auf der dem Bauteil gegenüberliegenden Seite der Leiterbahn vorgesehen ist. Bei einer Vielzahl von Bauteilen weist jedes Bauteil zwei Anschlussleitungen auf, wovon eine mittels einer Kontaktstelle mit der Leiterbahn leitend verbunden und die Kontaktstelle auf der den Bauteilen gegenüberliegenden Seite der Leiterbahn vorgesehen ist. Somit sind die Bauteile auf einer ersten Seite der Leiterbahn und die Kontaktstellen auf einer zweiten, der ersten Seite gegenüberliegenden Seite der Leiterbahn vorgesehen. Nachfolgend wird die erste Seite als Bauteileseite und die zweite Seite als Kontaktstellenseite bezeichnet. Die Anschlussleitungen verlaufen in herkömmlicher Weise durch die Leiterbahn, bzw. durch die Leiterplatte.

Bei der Anordnung von elektrischen Bauteilen nach der Erfindung sind auf der Bauteileseite der Leiterplatte keine Kontaktierungen mit der Leiterbahn erforderlich. Die Bauteile können somit dicht gepackt neben einander auf der Leiterplatte angeordnet werden und stören das Anbringen einer Kontaktierung, wie z. B. einer Verlötung nicht. Auf der Kontaktstellenseite sind die Orte für die Kontaktstellen ohne weiteres zugänglich und die Kontaktierung kann in einfacher Weise durchgeführt werden. Die Bauteile bilden mit der Leiterplatte eine kompakte Baueinheit und müssen nicht neben der Leiterplatte mit einer umständlichen Kontaktierung vorgesehen werden. Diese Art der Anordnung ist insbesondere bei Kondensatoren vorteilhaft, die für hohe Ströme ausgelegt sind. Derartige Kondensatoren sind herkömmlicher Weise nur als verdrahtete Bauteile erhältlich.

Grundsätzlich ist es möglich auf einer Leiterplatte neben einer Bauteileanordnung nach der Erfindung weitere Bauteile in herkömmlicher Weise auf der Leiterplatte anzubringen und anzuschliessen. Solche Bauteile, wie etwa SMD-Bauteile, werden z. B. auf der Bauteileseite der Leiterplatte durch die Oberfläche der Leiterplatte verlötet.

Die Bauteileanordnung ist besonders für die Steuerung bei elektrischen Antrieben vorgesehen. Insbesondere ist die Bauteileanordnung für eine Steuerschaltung bei bürstenlosen Antrieben mit elektronischer Kommutierung geeignet, kann aber auch für andere bürstenlose elektrische Einrichtungen, wie etwa Generatoren, vorteilhaft verwendet werden. Besonders geeignet ist die Bauteileanordnung für Niederspannungsantriebe, auch batteriebetriebene Niederspannungsantriebe.

Bei einer Ausführungsform der Bauteileanordnung nach der Erfindung ist die Leiterplatte aus Metall. Vorzugsweise besteht die Leiterplatte im Wesentlichen aus Kupfer. Kupfer weist eine hohe elektrische Leifähigkeit auf, ist kostengünstig in der Anschaffung und erlaubt eine einfache Verarbeitung. Anstelle von Kuper könnten z. B. Aluminium verwendet werden, wobei eine Kontaktstelle in Form einer Schweissstelle vorgesehen wird. Es ist auch mögliche, eine Aluminiumleiterplatte mit einer Kupferschicht oder einer lötfähigen Legierung zu verwenden, so dass als Kontaktstellen Lötstellen verwendet werden können.

Vorzugsweise weist die Metallleiterplatte eine Trennschicht auf, welche die Leiterplatte in eine Leiterebene als Leiterbahn und einen weiteren Leiter bzw. eine Masseebene trennt. Die Trennschicht kann als Isolationsschicht in Form eines Dielektrikums ausgebildet sein, beispielsweise als Prepreg-Schicht. Die Trennschicht verläuft im Wesentlichen parallel zur Ober- und Unterseite der Leiterplatte, bzw. zur Bauteileseite und Kontaktstellenseite, und überdeckt die Leiterbahn auf der den Bauteilen gegenüber liegenden Kontaktstellenseite. Zum Anbringen der Kontaktstelle zur Kontaktierung der ersten Anschlussleitung und zur Durchführung der zweiten Anschlussleitung wird die Trennschicht unterbrochen.

In einer Ausführungsform der Erfindung ist die zweite Anschlussleitung mittels einer weiteren Kontaktstelle mit einem Leiter, insbesondere der Masse, bzw. Erdung, verbunden. Die Masse kann durch die Masseebene in der Leiterplatte gegeben sein, die auf der den Bauteilen gegenüberliegenden Seite der Leiterbahn vorgesehen ist. Die Masse kann durch die Trennschicht von der Leiterbahn getrennt sein. Bei einer Metallleiterplatte aus Kupfer, bei der die Leiterbahn und die Masseebene aus Kupfer sind, beträgt die Dicke der Leiterbahn z. B. ca. ein Fünftel der Dicke der Masseebene und die Dicke der Trennschicht z. B. ca. ein Zehntel der Dicke der Masseebene. Die Kontaktstellen zur Kontaktierung der Anschlussleitungen mit der Leiterbahn und dem Leiter, bzw. der Masse, können unmittelbar mit diesen verbunden sein oder über ein Leitmittel, wie einer Legierung, hergestellt werden.

Bei der Bauteileanordnung verlaufen die erste und die zweite Anschlussleitung im Wesentlichen parallel zu einander durch die Leiterbahn und senkrecht zur Ebene der Leiterplatte. Dabei ist es vorteilhaft, dass die Anschlussleitungen geradlinig aus den Bauteilen heraus und durch die Durchgänge geführt werden können. Es ist kein Umlenken und Biegen der Anschlussleitungen erforderlich. Hierfür sind die Durchgänge für die Anschlussleitungen, die durch die Leiterplatte verlaufen, ebenfalls parallel zu einander vorgesehen und im Abstand auf den Abstand der aus den Kondensatoren austretenden Anschlussleitungen abgestimmt.

In einer Ausführungsform der Bauteileanordnung nach der Erfindung ist zumindest die Kontaktstelle zur Verbindung mit der Leiterbahn in der Leiterplatte versenkt vorgesehen ist, so dass sie nicht über die Oberfläche der Leiterplatte hervorsteht. Dadurch kann eine Kontaktierung mit der Leiterbahn erfolgen. Hierfür ist z. B. eine Aussparung in der Leiterplatte vorgesehen. Die Aussparung erstreckt sich durch die Masseebene und auch durch die Trennschicht. Der Durchgang in der Leiterplatte für die Anschlussleitung des Bauteils verläuft in diesem Fall von der Bauteileseite durch die Leiterbahn und mündet in die Aussparung. Der Durchmesser der Aussparung ist jedoch deutlich grösser als der Durchmesser des Durchgangs, z. B. etwa fünfmal grösser, so dass ausreichend Platz zum Anbringen der Kontaktstelle z. B. in Form einer Lötstelle ist.

Bei der Bauteileanordnung kann eine Schicht aus Dickkupfer als Leiterbahn verwendet werden. Als Dickkupfer ist ein Kupfer mit einer Dicke von mindestens 0.1 mm zu verstehen. Durch den Einsatz des Dickkupfers ist die Bauteileanordnung für Steuerschaltungen geeignet, die zur Kommutierung von sehr hohen Strömen im Bereich von 200 A und darüber vorgesehen sind.

In einer bevorzugten Ausführungsform ist bei der Bauteileanordnung nach der Erfindung die Leiterplatte mit einer unteren Fläche, d. h. der Kontaktstellenseite, auf einer Oberfläche eines Trägers angeordnet. Der Träger ist vorzugsweise durch eine Oberfläche eines Kühlkörpers gegeben. Der Träger, bzw. der Kühlkörper kann insbesondere durch eine Oberfläche eines Gehäuses für die Steuerschaltung oder eine die Steuerschaltung verwendende Vorrichtung sein. Der Kühlkörper ist wärmeleitend, vorzugsweise ist der Kühlkörper zumindest Grösstenteils aus Aluminium. Die Leiterplatte kann unmittelbar auf dem Kühlkörper aufliegen oder über eine thermische Lage, wie einer thermischen Paste, mit dieser verbunden sein. Die Kontaktstelle zur Verbindung der zweiten Anschlussleitung des Bauteils mit dem Leiter, bzw. der Masse, kann in dem Kühlkörper versenkt vorgesehen sein. Hierfür kann im Kühlkörper eine Vertiefung ausgebildet sein, in welche die Kontaktstelle für den Leiter hineinragt. Vorzugsweise erstreckt sich die Vertiefung über beide Durchgänge eines jeden Kondensators, so dass die Durchgänge durch die Leiterplatte in die Vertiefung des Kühlkörpers münden. Vorzugsweise ist für jeden Kondensator eine eigene Vertiefung im Kühlkörper vorgesehen. Grundsätzlich kann aber auch eine gemeinsame Vertiefung für alle Kondensatoren vorgesehen werden. Auf Grund der Vertiefung kann die Leiterplatte grossflächig auf der Oberfläche des Kühlkörpers aufliegen, so dass eine grossflächige thermische Kontaktierung und somit eine gute Wärmeableitung der elektrischen Bauteile gegeben ist.

Die Leiterplatte kann mit einer Verschraubung, die von der Bauteilseite durch die Leiterplatte in den Träger, bzw. den Kühlkörper, verläuft, am Träger befestigt werden. Vorzugsweise wird eine Metallschraube verwendet, die auch als elektrische Verbindung der Leiterbahn mit dem Leiter, bzw. der Masse, dient, verwendet. Die Verschraubung dient somit als leitfähiges Befestigungsmittel zur Befestigung der Bauteileanordnung auf dem Träger. Das Befestigungsmittel kann somit Bestandteil der elektrischen Verschaltung einzelner Bauteile der Bauteileanordnung sein. Darüber hinaus ermöglicht eine Metallschraube eine gute thermische Kontaktierung und erlaubt das Durchleiten hoher Ströme. Alternativ zur beschriebenen Verschraubung könnte auch eine Metallisierung von Bohrlöchern zur Durchkontaktierung verwendet werden

Vorzugsweise ist entlang der Oberfläche des Kühlkörpers, die der Oberfläche mit der Leiterplatte gegenüberliegt, eine Kühlung vorgesehen. Der Kühlkörper bildet damit einen Wärmetauscher zur Ableitung der Wärme der Steuerschaltung, insbesondere deren Bauteile. Die Kühlung kann durch eine Kühlleitung, durch die ein Kühlmedium, wie etwa Öl, geleitet wird, realisiert sein. Hierfür kann z. B. vorteilhaft ein Hydrauliköl einer Hydraulikeinrichtung verwendet werden. Die Kühlleitung kann an einen Kühlkreislauf oder Hydraulikkreislauf angeschlossen sein, der mittels einer Pumpe betrieben wird.

Gemäss der vorliegenden Erfindung ist die Bauteileanordnung vorteilhaft in einer Steuerschaltung zur elektronischen Kommutierung bei einem elektrischen Antriebsmotor, insbesondere bei einem bürstenlosen Gleichstrommotor, vorgesehen. Eine derartige Steuerschaltung kann platzsparend in dem Motor untergebracht werden, auch wenn eine Vielzahl von Bauteilen, insbesondere Kondensatoren, bei der Steuerung des Motors erforderlich sind. Die Bauteile und die Leiterplatte bilden eine Einheit, die zuverlässig arbeitet und wenig störanfällig ist. Somit kann die Steuerschaltung auch an wenig zugänglichen Bereichen im Motor angeordnet werden.

Ein elektrischer Antriebsmotor nach der Erfindung weist ein zylindrisches Gehäuse auf, innerhalb dem eine ortsfeste ringförmige Spulenanordnung und ein drehbarer Rotor um eine Antriebsachse angeordnet ist. Die Leiterplatte der Steuerschaltung ist vorzugsweise in einem Bereich zwischen der Achse und einem Innenumfangsdurchmesser der Spulenanordnung vorgesehen. Vorzugsweise erstreckt sich dabei die Leiterplatte radial über die Länge des Rotors, aber nicht über die Spulenanordnung. Grundsätzlich ist es aber auch denkbar, dass sich die Leiterplatte bis zum Aussenumfang der Spulenanordnung erstreckt. Die Leiterplatte weist eine mittlere Öffnung auf, durch welche die Antriebsachse geführt wird. Das Gehäuse des Motors kann z. B. den Kühlkörper für die Bauteileanordnung bilden. Dabei wird die Kontaktstellenseite der Leiterplatte grossfächig auf einer Fläche des Gehäuses angeordnet.

Für den Betrieb von bürstenlosen Antriebsmotoren, die für Anwendungen mit einer hohen Momentenbelastung vorgesehen sind, wie z. B. bei Liftanalgen in Form von Treppenliften, werden für die elektronische Kommutierung Kondensatoren eingesetzt, die für hohe Ströme ausgelegt sein müssen. Derartige Kondensatoren weisen sich durch eine grosse Baugrösse im Vergleich Kondensatoren auf herkömmlichen Chip-Anordnungen aus. Gerade für solche Kondensatoren ist es wichtig eine raumsparende Anordnung, eine gute thermische Ableitung und zuverlässige Kontaktierung, wie es die Bauteileanordnung nach der Erfindung ermöglicht, zu realisieren. Die Steuerschaltung mit einer Bauteileanordnung nach der Erfindung bildet somit eine kompakte und leistungsstarke Leistungseinheit für den Antriebsmotor, die in den Motor integriert werden kann.

Die Erfindung wurde an Hand einiger Ausführungsformen dargestellt. Die einzelnen technischen Merkmale einer Ausführungsform können durchaus auch in Kombination mit einer anderen Ausführungsform mit den dargelegten Vorteilen verwendet werden. Die Beschreibung der erfindungsgemässen technischen Merkmale ist daher nicht auf die jeweilige Ausführungsform beschränkt.

Vorteilhafte Ausführungsformen der Erfindung werden im Folgenden anhand der Zeichnungen dargestellt, die lediglich zur Erläuterung dienen und nicht einschränkend auszulegen sind. Aus den Zeichnungen offenbar werdende Merkmale der Erfindung sollen einzeln und in jeder Kombination als zur Offenbarung der Erfindung gehörend betrachtet werden. In den Zeichnungen zeigen:
Fig. 1: schematischer Längsschnitt durch eine Ausführungsform einer
   Bauteileanordnung nach der vorliegenden Erfindung und
Fig. 2: Schnittdarstellung durch eine Ausführungsform eines elektrischen
   Antriebs mit einer Bauteileanordnung nach der Erfindung.

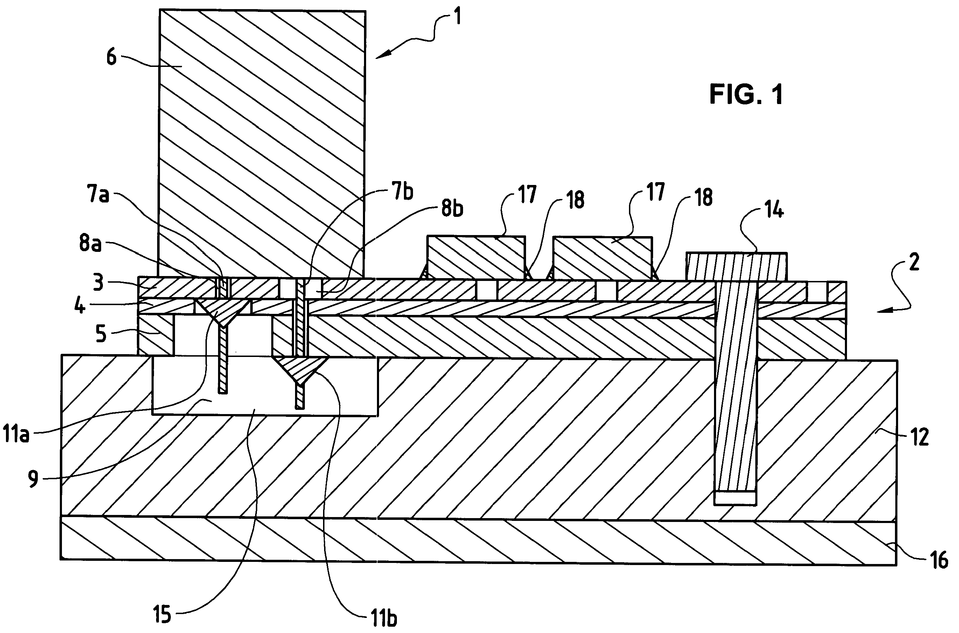

In Figur 1 ist eine Ausführungsform einer Anordnung eines Kondensators 1 auf einer Leiterplatte 2 schematisch dargestellt. Der Kondensator 1 ist stellvertretend für eine Vielzahl von elektrischen Bauteilen gezeigt, die auf einer Seite, der Kondensatorseite, bzw. der Bauteilseite, der Leiterplatte angeordnet sind. Der Kondensator 1 und die Leiterplatte 2 bilden eine Bauteileanordnung, die vorzugsweise zur elektronischen Kommutierung verwendet wird. Das Prinzip der Kommutierung ist aus dem Stand der Technik bekannt und wird daher hier nicht weiter ausgeführt.

Die Leiterplatte 2 weist eine Leiterbahn 3, eine Trennschicht 4 aus Prepreg-Material und eine Masseebne 5 auf. Die Leiterplatte besteht im Wesentlichen aus Kupfer, so dass die Leiterbahn 3 eine Kupferleiterbahn ist. Die Masseebene 5 ist ebenfalls aus Kuper und bildet somit eine Kupferträgerschicht für die Leiterplatte. Die Leiterbahn 3 ist ca. 0.2 mm, die Masseebne 5 ca. 1.0mm und die Trennschicht ca. 0.1 mm dick. Das Prepreg-Material der Trennschicht besteht aus Epoxy mit Keramikpulver.

Der Kondensator 1 umfasst einen Kondensatorkörper 6 und zwei Anschlussleitungen 7a und 7b, die beabstandet von einander aus einer Seite des Kondensatorkörpers 6 in Richtung der Leiterplatte 2 ragen. Der Kondensatorkörper 6 kann auf der Leiterplatte z. B. durch eine Verklebung befestigt sein. Im Bereich der Leiterplatte, auf dem der Kondensator 1 platziert wird, sind Durchgänge 8a und 8b durch die Leiterplatte 2 vorgesehen. Die Durchgänge 8a und 8b sind im gleichen Abstand wie die Anschlussleitungen 7a und 7b zu einander angeordnet und verlaufen im Wesentlichen senkrecht zu einer Ebene der Leiterplatte 2. Der Durchgang 8a für die Anschlussleitung 7a mündet auf der dem Kondensator 1 gegenüber liegenden Seite in eine Aussparung 9 in der Leiterplatte 2. Die Aussparung 9 durchbricht die Masseebene 5 und die Trennschicht 4, so dass sie in der Leiterbahn 3 endet. Der Durchgang 8b für die Anschlussleitung 7b weist durch die Leiterbahn 3 einen vergrösserten Durchmesserbereich auf im Vergleich zum Durchmesser im Bereich der Trennschicht 4 und der Masseebene 5.

Entsprechend der vorliegenden Erfindung ist der Kondensator 1 auf einer Seite einer Leiterbahn 2 auf der Leiterplatte 3 vorgesehen und die zwei Anschlussleitungen 7a und 7b ragen durch die Durchgänge 8a und 8b in der Leiterplatte 2. Die Anschlussleitung 7a ist mittels einer Kontaktstelle in Form einer Lötstelle 11 a mit der Leiterbahn 3 leitend verbunden, wobei die Lötstelle 11 a auf der gegenüberliegenden Seite der Leiterbahn 3 vorgesehen ist und innerhalb der Aussparung 9 versenkt ist. Im Fall von einer Vielzahl von Bauteilen, wie den Kondensatoren 1, ist jeweils eine der beiden Anschlussleitungen der Kondensatoren durch einen Durchgang in der Leiterplatte 2 durch eine Lötstelle mit der Leiterbahn 3 verbunden. Somit weist die Leiterplatte 2 eine Vielzahl von Durchgängen 8a für die Vielzahl von Anschlussleitung 7a der Kondensatoren auf. Die Vielzahl von Anschlussleitung 7a werden durch eine Vielzahl von Lötstellen 11 a mit der Leiterbahn 3 verbunden. Die Seite der Leiterplatte 2 mit den Lötstellen 11a bildet die Kontaktstellenseite. Die Leiterplatte kann dementsprechend eine Vielzahl von Aussparungen 9 aufweisen, wobei eine Aussparung auch mehrere Durchgänge 7a einschliessen kann. Beispielsweise kann eine Aussparung für mehrere Durchgänge in Form einer Rille in der Masseebene 5 ausgebildet sein.

Die zweite Anschlussleitung 7b ragt durch den Durchgang 8b bis zur gegenüberliegenden Seite der Leiterplatte 2 und aus dieser hervor. Die zweite Anschlussleitung 7b ist mittels einer zweiten Kontaktstelle in Form einer Lötstelle 11 b mit der Masseebene 5 leitend verbunden. Die Masseebene 5 bildet einen Leiter, insbesondere eine Masse, für den Kondensator 1. Bei einer Vielzahl von Kondensatoren 1 liegen entsprechend eine Vielzahl von zweiten Lötstellen 11 b vor. Durch die beschriebene Kontaktierung der Anschlussleitungen 7a und 7b der Kondensatoren 1 mit der Leiterbahn 3 und der Masseebene 5 sind die Kondensatoren parallel verschaltet. Ferner verlaufen die Anschlussleitungen 7a und 7b quer zu einer Ebene der Leiterplatte 2. Die Lötstellen 11 b sind auf der Oberfläche der Leiterplatte 2 angeordnet. Grundsätzlich kann auch für die Lötstellen 11 b eine Einbuchtung in der Masseebene 5 vorgesehen werden, die jedoch noch innerhalb der Masseebene 5 endet, so dass eine Kontaktierung mit der Masseebene 5 sichergestellt werden kann.

Als Lötstelle ist eine elektrische Kontaktstelle zwischen einer Anschlussleitung 7a, 7b und der Leiterbahn 3, bzw. der Masseebene 5, zu verstehen, die durch eine stoffschlüssige Verbindung zwischen dem Material der Anschlussleitungen und dem Material der Leiterbahn, bzw. der Masseebene, hergestellt wird. Zur Verbesserung des elektrischen Kontakts können auch Hilfsmaterialen in der Lötstelle verwendet werden, wie z. B. eine auf die Materialien abgestimmte Metalllegierung. Grundsätzlich sind auch andere Arten von Kontaktstellen denkbar, beispielsweise eine Schweissstelle, wie es zur Kontaktierung mit Aluminium durchgeführt wird, oder eine Verschraubung mit der Leiterbahn.

In der gezeigten Ausführungsform einer Bauteileanordnung nach der Erfindung ist die Leiterplatte 2 auf einem Kühlkörper 12 angeordnet, der einen Träger für die Leiterplatte 2 bildet. Der Kühlkörper 12 ist z. B. Teil eines Gehäuses einer elektrischen Vorrichtung, insbesondere eines elektrischen Antriebs. Der Kühlkörper 12 ist vorzugsweise aus Aluminium und ermöglicht somit eine gute Wärmeleitung. Zudem kann zwischen der Leiterplatte 2 und dem Kühlkörper 12 eine thermische Kontaktlage (nicht gezeigt) z. B. in Form einer thermischen Paste vorgesehen werden, um den Wärmeübergang zu verbessern.

Die Leiterplatte 2 kann mittels Schrauben 14 auf dem Kühlkörper12 befestigt sein. Die Schrauben 14 können mit der Masse in Form der Masseebene 5 elektrisch kontaktiert sein. Die Schrauben 14 dienen somit zum Einen zur Befestigung der Leiterplatte auf dem Träger. Zum Anderen dienen sie zur Stromleitung zwischen dem Kondensator 1 durch die Anschlussleitungen 7b, die Masseebene 5, die Schraube 14 und die Leiterebene 3 zu einem weiteren Bauteil 17. Die Stromleitung von dem Kondensator 1 erfolgt dagegen unmittelbar über die Anschlussleitung 7a und durch die Leiterbahn 3.

Im Bereich der Lötstellen 11 a und 11 b weist der Kühlkörper 12 eine Vertiefung 15 auf, in welche die Lötstelle 11 b hineinragen kann. Die Vertiefung 15 erstreckt sich auch über die die Aussparung 9 und somit über die Lötstelle 11 a. Bei mehreren Kondensatoren kann für jedes Anschlussleitungspaar eine eigene Vertiefung vorgesehen werden oder es kann eine vergrösserte Vertiefung vorliegen, die sich über mehrere Anschlussleitungspaare erstreckt.

Auf der Seite des Kühlkörpers 12, die der Leiterplatte 2 gegenüber liegt, verläuft entlang dem Kühlkörper 12 eine Kühlleitung 16 mit einem Kühlmedium, wie etwa Öl. Die Kühlleitung 16 ist an einen Kühlkreislauf angeschlossen, der zur Kühlung der Leiterplatte 2 und der darauf angeordneten Bauteile über den Kühlkörper 12 dient. Die Kühlleitung 16 kann z. B. durch einen Kühlkreislauf gespeist werden. Vorzugsweise wird die Kühlleitung von einer Hydraulikeinrichtung, z. B. eines elektrischen Motors, unterhalten. Die Verwendung einer Hydraulikeinrichtung zum Betreiben einer Kühlung von elektrischen Leiterplatten und deren Bauteilen kann vorteilhaft auch ohne eine erfindungsgemässe Anordnung von Bauteilen auf der Leiterplatte verwendet werden. Es bleibt daher vorbehalten hierauf eine eigene Patentanmeldung zu richten.

Auf der Kondensatorseite der Leiterplatte 2 ist ein SMD-Bauteil 17 angeordnet, das in herkömmlicher Weise von der Oberseite der Leiterbahn 3 mit dieser durch Verlötung 18 kontaktiert ist. Im Gegensatz dazu sind die Kondensatoren nach der Erfindung auf der Unterseite der Leiterbahn 3 durch Lötstellen mit dieser kontaktiert. Das SMD-Bauteil 17 kann z. B. ein Transistor oder eine Spule sein. Es können weitere Bauteile der Steuerschaltung auf der Leiterplatte 2 angeordnet und elektrisch verschaltet werden. Es können auch zusätzliche Kondensatoren vorgesehen sein, die andere Funktionen als die Kondensatoren 1 haben und in herkömmlicher Weise verschaltet sind. Wie vorher beschrieben, wird das SMD-Bauteil 17 z. B. mit dem Kondensator 1 erstens über die Anschlussteitung 7a, die Leiterbahn 3 und die Verlötung 18 und zweitens über die Anschlussleitung 7b, die Masseebene 5, die Schraube 14 und die Leiterbahn 3 verbunden.

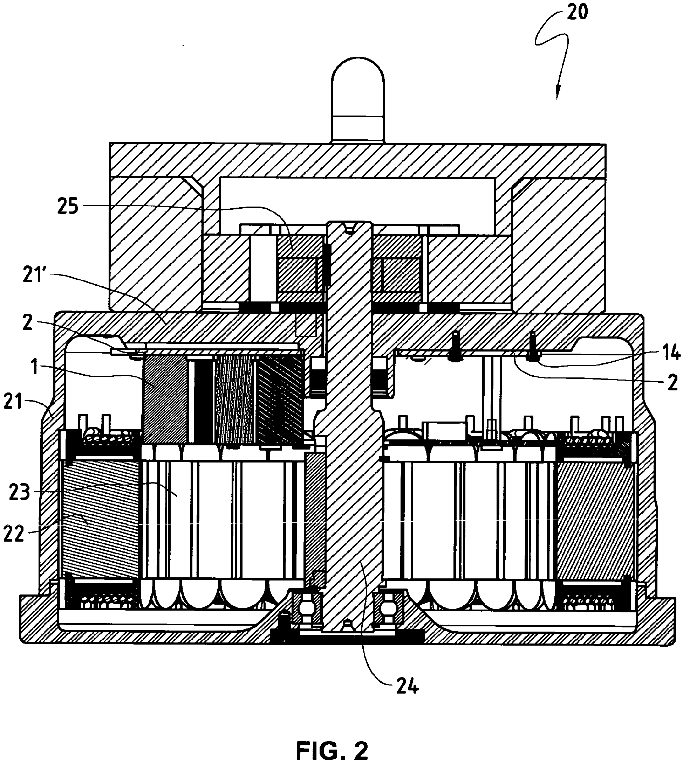

In Figur 2 ist eine Schnittdarstellung eines elektrischen Antriebsmotors in Form eines bürstenlosen Gleichstrommotors 20 nach der vorliegenden Erfindung mit einer Steuerschaltung gezeigt, die eine Bauteileanordnung, wie zu Figur 1 beschrieben, umfasst. Der Antriebsmotor 20 umfasst ein zylindrisches Gehäuse 21, eine ortsfeste ringförmige Spulenanordnung 22 und einen Rotor 23. Der Rotor 23 ist um eine Antriebsachse 24 drehbarer angeordnet. Die Funktionsweise von bürstenlosen Gleichstrommotoren im Allgemeinen ist aus dem Stand der Technik bekannt, so dass auf eine detaillierte Ausführung der Funktion hier verzichtet werden kann. Es werden lediglich die erfindungswesentlichen Elemente des Antriebsmotors bezeichnet.

Die Steuerschaltung des Motors 20 ist zur elektronischen Kommutierung der Stromversorgung des Motors vorgesehen. Die Leiterplatte 2 der Steuerschaltung ist in radialer Richtung in einem Bereich zwischen der Achse 24 und einem Innenumfangsdurchmesser der Spulenanordnung 22 an einer radial verlaufenden Fläche 21' des Gehäuses 21 vorgesehen. Auf der Leiterplatte 2 sind Kondensatoren 1 vorgesehen, die somit axial ausgerichtet sind und nicht radial über die Spulenanordnung 22 hinaus ragen. Das Gehäuse 21 dient als Lager für die Antriebsachse 24. Zudem dient das Gehäuse 21 mit der Fläche 21' als Kühlkörper 12, auf dem die Leiterplatte 2 angebracht ist. Die Leiterplatte 2 und die Kühlkörperfläche 21' des Gehäuses 21 erstrecken sich um die Achse 24, wofür jeweils eine zentrale Öffnung vorgesehen ist. Die Leiterplatte 2 ist mittels Schrauben 14 an der Kühlkörperfläche 21' befestigt. Eine Pumpeinrichtung 25 kann zur Versorgung des Kühlkreislaufs durch die Kühlleitung 16 im oder nahe des Gehäuses 21 vorgesehen sein. Vorzugsweise ist die Pumpeneinrichtung 25 auf der Seite der Kühlkörperfläche 21' angeordnet, die der Leiterplatte 2 gegenüber liegt.

Eine derartige Anordnung der elektrischen Steuerschaltung mit einer Bauteileanordnung nach der Erfindung in dem bürstenlosen Gleichstrommotor 20 erlaubt eine kompakte und kostengünstig Bauweise.

### Bezugszeichen

- 1: Kondensator
- 2: Leiterplatte
- 3: Leiterbahn
- 4: Trennschicht
- 5: Masseebne/Erdung
- 6: Kondensatorkörper
- 7a, 7b: Anschlussleitung
- 8a, 8b: Durchgänge
- 9: Aussparung
- 11a, 11b: Lötstelle
- 12: Kühlkörper
- 14: Schraube
- 15: Vertiefung
- 16: Kühlleitung
- 17: SMD
- 18: Verlötung
- 20: elektrischer Motor
- 21,21': Motorgehäuse
- 22: Spulenanordnung
- 23: Rotor
- 24: Antriebsachse
- 25: Pumpeneinrichtung

## Patentansprüche

1. Bauteileanordnung für eine elektrische Steuerschaltung, insbesondere zur Steuerung elektrischer Antriebe, umfassend eine Leiterplatte (2) mit wenigstens einer Leiterbahn (3) und wenigstens ein auf der Leiterplatte angeordnetes elektrisches Bauteil (1), dass wenigstens zwei Anschlussleitungen (7a, 7b) aufweist, die durch Durchgänge (8a, 8b) in der Leiterplatte (2) ragen, wobei wenigstens eine der Anschlussleitungen (7a) mittels einer Kontaktstelle (11a) mit einer Leiterbahn (3) leitend verbunden ist, die auf der gegenüberliegenden Seite der Leiterbahn vorgesehen ist
**dadurch gekennzeichnet, dass**
das wenigstens eine Bauteil (1) auf der Seite der Leiterbahn (3) auf der Leiterplatte (2) vorgesehen ist.

2. Bauteileanordnung nach Anspruch 1, **dadurch gekennzeichnet, dass** eine Vielzahl von elektrischen Bauteilen (1) vorgesehen ist, die jeweils wenigstens zwei Anschlussleitungen (7a, 7b) aufweisen, wovon wenigstens eine mittels einer Kontaktstelle (11a) mit der Leiterbahn (3) leitend verbunden ist, die auf der gegenüberliegenden Seite der Leiterbahn vorgesehen.

3. Bauteileanordnung nach Anspruch 1 oder 2, **dadurch gekennzeichnet, dass** die Leiterplatte (2) aus Metall, vorzugsweise aus Kupfer, besteht.

4. Bauteileanordnung nach einem der vorhergehenden Ansprüche, **dadurch gekennzeichnet, dass** eine Trennschicht (4) die Leiterplatte (2) in eine Leiterebene als Leiterbahn (3) und eine Masseebene (5) trennt.

5. Bauteileanordnung nach einem der vorhergehenden Ansprüche, **dadurch gekennzeichnet, dass** die zweite Anschlussleitung (7b) mittels einer Kontaktstelle (11 b) mit einem Leiter, insbesondere der Masseebene (5), verbunden ist, die auf der dem Bauteil (1) gegenüberliegenden Seite der Leiterbahn (3) vorgesehen ist.

6. Bauteileanordnung nach einem der vorhergehenden Ansprüche, **dadurch gekennzeichnet, dass** die erste und die zweite Anschlussleitung (7a, 7b) im Wesentlichen parallel zu einander durch die Leiterbahn (3) und senkrecht zur Ebene der Leiterplatte (2) verlaufen.

7. Bauteileanordnung nach einem der vorhergehenden Ansprüche, **dadurch gekennzeichnet, dass** zumindest die Kontaktstelle (11 a) zur Verbindung mit der Leiterbahn (3) in der Leiterplatte versenkt vorgesehen ist.

8. Bauteileanordnung nach einem der vorhergehenden Ansprüche, **dadurch gekennzeichnet, dass** die Leiterplatte (2) mit einer Verschraubung auf einem Träger befestigt ist, die durch die Leiterbahn (3) und die Masseebene (5) verläuft.

9. Bauteileanordnung nach einem der vorhergehenden Ansprüche, **dadurch gekennzeichnet, dass** die Leiterplatte (2) mit einer Fläche auf einer Oberfläche eines Kühlkörpers (12) angeordnet ist.

10. Bauteileanordnung nach dem vorhergehenden Anspruch, **dadurch gekennzeichnet, dass** die Kontaktstelle (11 b) zur Verbindung mit dem Leiter in dem Kühlkörper (12) versenkt vorgesehen ist.

11. Bauteileanordnung nach einem der Ansprüche 9 oder 10, **dadurch gekennzeichnet, dass** entlang der der Leiterplatte (2) gegenüber liegenden Oberfläche des Kühlkörpers (12) eine Kühlung (16) vorgesehen ist.

12. Bauteileanordnung nach einem der vorhergehenden Ansprüche, **dadurch gekennzeichnet, dass** die Bauteileanordnung in einer Steuerschaltung zur elektronischen Kommutierung bei einem bürstenlosen Gleichstrommotor (20) vorgesehen ist.

13. Elektrischer Antriebsmotor mit einer Steuerschaltung, die eine Bauteileanordnung nach einem der Ansprüche 1 bis 13 umfasst.

14. Elektrischer Antriebsmotor nach Anspruch 13, **dadurch gekennzeichnet, dass** ein zylindrisches Gehäuse (21) vorgesehen ist, wobei innerhalb des Gehäuses (21) eine ortsfeste ringförmige Spulenanordnung (22) und um eine Antriebsachse (24) ein drehbarer Rotor (23) angeordnet ist,
wobei die Leiterplatte (2) der Steuerschaltung in einem Bereich zwischen der Antriebsachse (24) und einem Innenumfangsdurchmesser der Spulenanordnung (22) vorgesehen ist.

15. Elektrischer Antriebsmotor nach Anspruch 13 oder 14, **dadurch gekennzeichnet, dass** eine Hydraulikeinrichtung des Motors die Kühlung (16) betreibt.

## Claims

1. An arrangement of components for an electrical control circuit, in particular for the control of electric drives, comprising a circuit board (2) with at least one conductor track (3) and at least one electric component (1) arranged on the circuit board, which comprises at least two connecting lines (7a, 7b) protruding through through-passages (8a, 8b) in the circuit board (2), wherein at least one of the connecting lines (7a) is conductively connected via a contact point (11a) with a conductor track (3) provided on the opposite side of the conductor track, **characterised in that** the at least one component (1) is provided on the circuit board (2) on the side of the conductor track (3).

2. The arrangement of components according to claim 1, **characterised in that** a plurality of electric components (1) are provided, each of which comprises at least two connecting lines (7a, 7b), of which at least one is conductively connected with the conductor track (3) via a contact point (11a), which is arranged on the opposite side of the conductor track.

3. The arrangement of components according to claim 1 or 2, **characterised in that** the circuit board (2) consists of metal, preferably of copper.

4. The arrangement of components according to one of the preceding claims, **characterised in that** a dividing layer (4) divides the circuit board (2) into a conductor plane as the conductor track (3) and a ground plane (5).

5. The arrangement of components according to one of the preceding claims, **characterised in that** the second connecting line (7b) is connected via a contact point (11b) with a conductor, in particular the ground plane (5), which is arranged on that side of the conductor track (3) which is opposite the component (1).

6. The arrangement of components according to one of the preceding claims, **characterised in that** the first and second connecting lines (7a, 7b) essentially extend in parallel to each other through the conductor track (3) and at right angles to the plane of the circuit board (2).

7. The arrangement of components according to one of the preceding claims, **characterised in that** at least the contact point (11a) for connection to the conductor track (3) is arranged recessed in the circuit board.

8. The arrangement of components according to one of the preceding claims, **characterised in that** the circuit board (2) is fastened to a carrier by means of a screw joint extending through the conductor track (3) and the ground plane (5).

9. The arrangement of components according to one of the preceding claims, **characterised in that** the circuit board (2), with one surface, is arranged on a surface of the cooling body (12).

10. The arrangement of components according to the preceding claim, **characterised in that** the contact point (11b) for connection to the conductor is arranged recessed in the cooling body (12).

11. The arrangement of components according to one of claims 9 or 10, **characterised in that** cooling (16) is arranged along the surface of the cooling body (12) lying opposite to the circuit board (2).

12. The arrangement of components according to one of the preceding claims, **characterised in that** the arrangement of components in a control circuit is provided for electronic commutation in case of a brushless direct current motor (20).

13. Electric drive motor with a control circuit, which comprises an arrangement of components according to one of claims 1 to 13.

14. An electric drive motor according to claim 13, **characterised in that** a cylindrical housing (21) is provided, wherein the housing (21) has a fixed ringshaped coil array (22) and a rotor (23) rotatable about a drive axis (24) arranged within it, wherein the circuit board (2) of the control circuit is provided in an area between the drive axis (24) and an inner circumference diameter of the coil array (22).

15. The electric drive motor according to claim 13 or 14, **characterised in that** the hydraulic device of the motor operates the cooling (16).

## Revendications

1. Agencement de composants pour un circuit de commande , en particulier pour la commande d'entraînements électriques, comprenant une plaque de circuits imprimés (2) avec au moins une piste conductrice (3) et au moins un composant (1) électrique disposé sur la plaque de circuits imprimés, qui comporte au moins deux lignes de connexion (7a, 7b), qui dépassent dans la plaque de circuits imprimés (2) par des passages (8a, 8b), au moins une des lignes de connexion (7a) étant reliée de manière conductrice au moyen d'un point de contact (11a) avec une piste conductrice (3), qui est prévue sur le côté opposé de la piste conductrice, **caractérisé en ce qu'**au moins un composant (1) est prévu sur le côté de la piste conductrice (3) sur la plaque de circuits imprimés (2).

2. Agencement de composants selon la revendication 1, **caractérisé en ce qu'**une pluralité de composants électriques (1) est prévue, ceux-ci comportant respectivement au moins deux lignes de connexion (7a, 7b), desquelles au moins une est reliée de manière conductrice à la piste conductrice (3) au moyen d'un point de contact (11a), qui est prévu sur le côté opposé de la piste conductrice.

3. Agencement de composants selon la revendication 1 ou 2, **caractérisé en ce que** la plaque de circuits imprimés (2) est composé de métal, de préférence de cuivre.

4. Agencement de composants selon l'une quelconque des revendications précédentes, **caractérisé en ce qu'**une couche de séparation (4) sépare la plaque de circuits imprimés (2) dans un plan conducteur en tant que piste conductrice (3) et un plan de masse (5).

5. Agencement de composants selon la revendication 1, **caractérisé en ce que** la deuxième ligne de connexion (7b) est reliée au moyen d'un point de contact (11b) à un conducteur, en particulier du plan de masse (5), qui est prévu sur le côté opposé au composant (1) de la piste conductrice (3).

6. Agencement de composants selon l'une quelconque des revendications précédentes, **caractérisé en ce que** la première et la deuxième ligne de connexion (7a, 7b) passent pour l'essentiel parallèlement l'une à l'autre par la piste conductrice (3) et perpendiculairement au plan de la plaque de circuits imprimés (2).

7. Agencement de composants selon l'une quelconque des revendications précédentes, **caractérisé en ce qu'**au moins le point de contact (11a) est prévu noyé dans la plaque de circuits imprimés pour raccordement avec la piste conductrice (3).

8. Agencement de composants selon la revendication 1 selon l'une quelconque des revendications précédentes, **caractérisé en ce que** la plaque de circuits imprimés (2) est fixée sur un support avec un raccord à vis, qui passe par la plaque de circuits imprimés (3) et le plan de masse (5).

9. Agencement de composants selon la revendication 1 selon l'une quelconque des revendications précédentes, **caractérisé en ce que** la plaque de circuits imprimés (2) est disposée avec une face sur une surface supérieure d'un dissipateur thermique (12).

10. Agencement de composants selon l'une quelconque des revendications précédentes, **caractérisé en ce que** le point de contact (11b) est prévu noyé dans le dissipateur thermique (12) pour raccordement au conducteur.

11. Agencement de composants selon la revendication 9 ou 10 précédentes, **caractérisé en ce qu'**un élément de refroidissement (16) est prévu le long de la surface supérieure du dissipateur thermique (12), opposée à la plaque de circuits imprimés (2).

12. Agencement de composants selon l'une quelconque des revendications précédentes, **caractérisé en ce que** l'agencement de composants est prévu dans un circuit de commande pour la commutation électronique pour un moteur à courant continu sans balais (20).

13. Moteur d'entraînement électrique avec un circuit de commande, qui comprend un agencement de composants selon l'une quelconque des revendications 1 à 13.

14. Moteur d'entraînement électrique selon la revendication 13, **caractérisé en ce qu'**un boîtier cylindrique (21) est prévu, un agencement de bobines (22) fixe de forme annulaire et un rotor (23) pouvant tourner autour d'un axe d'entraînement (24) étant disposés à l'intérieur du boîtier (21), la plaque de circuits imprimés (2) du circuit de commande étant prévue dans une zone située entre l'axe d'entraînement (24) et un diamètre périphérique intérieur de l'agencement de bobines (22).

15. Moteur d'entraînement selon la revendication 13 ou 14, **caractérisé en ce qu'**un dispositif hydraulique du moteur actionne l'élément de refroidissement (16).
